# EUROPÄISCHE PATENTSCHRIFT

(11) **EP 2 469 608 B1**
(45) Veröffentlichungstag und Bekanntmachung des Hinweises auf die Patenterteilung: **05.09.2018**
(21) Anmeldenummer: 10016068.8
(22) Anmeldetag: 24.12.2010
(51) Int. Cl.: H01L 31/068, H01L 31/0352, H01L 31/075

(54) **Bipolardiode mit optischem Quantenstrukturabsorber**
Bipolar diode with optical quantum structure absorber
Diode bipolaire dotée d'un absorbeur de structure quantique optique

(43) Veröffentlichungstag der Anmeldung: 27.06.2012
(73) Patentinhaber: Dechamps & Sreball GbR, 52066 Aachen (DE)
(72) Erfinder: Schüppen, Andreas Paul, Dr. Ing., 52066 Aachen (DE)
(74) Vertreter: Szynka, Dirk

(56) Entgegenhaltungen:
- WO-A1-03/012881
- JP-A- 2 246 284
- US-A- 5 446 293
- US-A1- 2010 186 802
- US-B1- 7 202 411

## Beschreibung

Es wird eine neuartige Silizium basierte, einstufige Solarzelle vorgeschlagen, die anstelle der Lichtumwandlung im inneren eines aus der Schmelze gezogenen Halbleitermaterials die Stromerzeugung innerhalb einer sehr dünnen aufgebrachten Quantenstruktur nutzt. Dabei besteht die Schichtfolge selbst als aktiver Absorber aus einer dreifachen Heterostruktur, die in die Raumladungszone eines pn-Übergangs eingebetet ist und quantenmechanische Effekte nutzt.

Dabei wird die Schicht vorzugsweise mittels eines CVD- oder ähnlichen Verfahrens aufgebracht. Es konnten an kleinen Mustern auf Silizium Wirkungsgrade von über 30% gemessen werden.

### Stand der Technik

Zurzeit gibt es viele verschiedene Arten und Materialien innerhalb der Photovoltaik Strom aus der Sonnenstrahlung zu gewinnen. Allen voran sind die einkristalline und multikristalline Silizium Solarzellen mit einem pn-Übergang zu nennen, die in der Forschung Wirkungsgrade von ca. 23% erzielt haben und in der Produktion typischerweise 17-20% liefern. Diese Solarzellen zeichnen sich vor allem durch ihre Einfachheit, Wirtschaftlichkeit, gute Umweltverträglichkeit und geprüfte Langzeitstabilität aus. Darüber hinaus gibt es silizium basierte Dünnschichtzellen, bei denen ein oder mehrere pn-Übergänge mittels eines CVD Verfahrens auf Glas aufgebracht werden. Diese Solarzellen liefern derzeit jedoch in der Produktion noch bescheidene Wirkungsgrade von lediglich 5-8%. Dabei scheint die Langzeitstabilität bei diesen Zellen noch nicht eindeutig geklärt zu sein. Dünnschichtzellen bestehen heute häufig schon aus zwei auf einander gestapelten pn-Übergängen, die sogeannten Tandemzellen. Des Weiteren gibt es II-VI und III-V basierte Solarzellen. CdTe und CIGS Dünnschichtzellen, sind zwar äußerst wirtschaftlich in der Herstellung und erzielen Wirkungsgrade von bis zu 20% in der Forschung, doch sind die eingesetzten Materialien sehr umstritten, da sie zum einen sehr selten sind und zum anderen als Umweltgifte eingestuft sind.

GaAs basierte Solarzellen werden schon sehr lange in der Raumfahrt erfolgreich eingesetzt. Sie werden häufig als sogenannte Triple Junction Cells ausgeführt, bei denen drei pn-Übergänge übereinander gestapelt sind, die jeweils unterschiedliche Frequenzbänder des Sonnenlichts in Strom umwandeln. Der Stand der Technik von Solarzellen bzgl. deren Wirkungsgrade wird in der folgenden Tabelle zusammengefasst:
▪ Weltrekord
   Crystalline Silicon 23.2%
   Crystalline III-V 42.8%
   Thin Film a-Si/c-Si 15.0%
   Thin Film CIGS 19.9%
   Thin Film CdTe 15,6%
   Organic Solar Cells 6,0 %
▪ Produktion
   Crystalline Silicon 16-20%
   Crystalline III-V 30-35%
   Thin Film a-Si 5-8%
   Thin Film CiGS 9-12%
   Thin Film CdTe 7-8%
   Organic Solar Cells - %

Unabhängig von der Art der Herstellung und des eingesetzten Materials haben alle derzeitigen sich in der Produktion befindlichen Solarzellen eines gemeinsam: sie basieren auf dem Standard Diodenprinzip, das heißt, dass sie aus einem oder mehreren pn-Übergängen bestehen. Dabei wird ein n-dotierter und ein p-dotierter Bereich eines Halbleitermaterials erzeugt. Der Übergang der beiden Bereiche bildet aufgrund des Konzentrationsgradienten zwischen Elektronen und Löchern eine sogenannte Raumladungszone und ein elektrisches Feld aus. Die in der Raumladungszone durch einfallendes Licht erzeugten Elektron-Loch Paare - photovoltaischer Effekt - werden durch die sogenannte Diffusionsspannung an die Klemmen der Diode bewegt und erzeugen bei Anschluss an einen Verbraucher zu einem Stromfluss und damit zu einer Energieerzeugung. Nachteile dieser Art der photovoltaischen Stromerzeugung sind vor allem, dass die Diffusionsspannung vor allem durch die Dotierung der beiden Gebiete bestimmt ist und die breite der Raumladungszone umgekehrt proportional zur Dotierung ist, d.h. wenn man die Diffusionsspannung vergrößert, verkleinert sich die Raumladungszone und damit das Gebiet in dem nutzbare Ladungsträger erzeugt werden können. Darüber hinaus muss dafür gesorgt werden, dass das Licht die Raumladungszone erreicht und nicht schon vorher absorbiert wird oder sogar ganz durch das Material dringt und somit zu wenig Wechselwirkung mit den Valenzelektronen der Atome der Raumladungszone hat. Dadurch nutzen herkömmliche Solarzellen immer nur einen Teil des Lichtspektrums und die intern generierten Ladungsträger können oft aufgrund der Ortsabhängigkeit der Generation, z.B. außerhalb der Raumladungszone nicht zum Stromfluss beitragen, da sie nach ihrer Generation bevor sie die Klemmen der Diode erreichen wieder rekombinieren.

Schon Ende der siebziger Jahre wurden sogenannte Quantenstrukturen vorgeschlagen, die viele Hetero-Übergänge hintereinander geschaltet haben, um diesem Dilemma zu entgehen. Jedoch konnten bis heute keine nennenswerte Erfolge an solchen Strukturen gezeigt werden. Auch auf Grund der Komplexität und der damit verbundenen Unwirtschaftlichkeit solcher Strukturen wurde in der Industrie dieser Ansatz nicht weiter verfolgt.

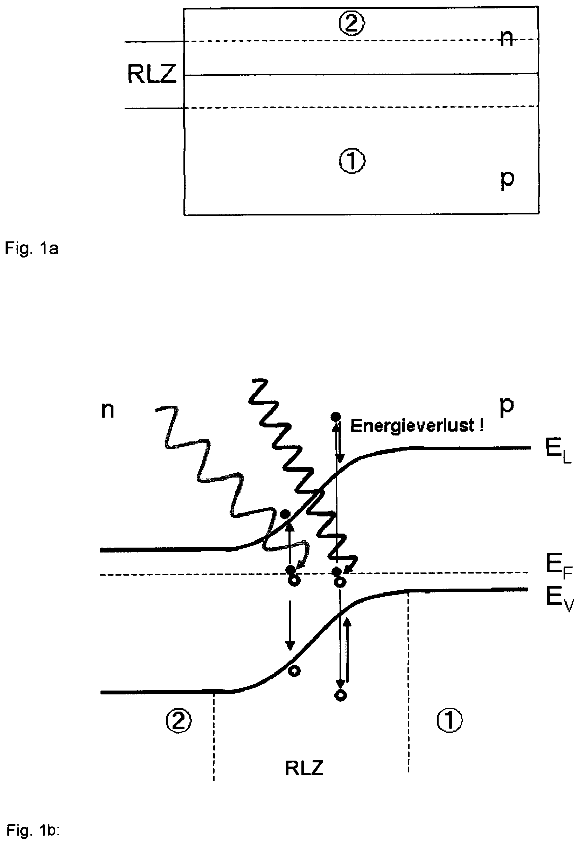

Wie in der Fig. 1a schematisch dargestellt ist, werden zurzeit mono- und polykristalline Solarzellen mit Hilfe eines p-n-Übergangs im inneren der Solarzelle hergestellt. Dabei liegt der p-n-Übergang üblicherweise einige hundert Nanometer unterhalb der Zelloberfläche. Die Photonenenergie des einfallenden Lichts wird in diesen Zellen nur teilweise genutzt, da z.B. Licht im Infrarotbereich eine zu große Wellenlänge hat, können Elektron-Loch-Paare nicht erzeugt werden. Licht mit z.B. Wellenlängen von ca. 900 - 1100nm liegen in der Nähe der Bandlückenenergie von Silizium und werden zum Großteil in elektrische Energie umgesetzt. Hingegen blaues und ultra violettes Licht erzeugen zwar Elektron-Loch-Paare, die jedoch eine zu hohe Energie haben und in den Bahngebieten der Solarzelle wieder thermalisieren, d.h. Energie verlieren und in Wärme umwandeln. Theoretische Berechnungen zeigen, dass Wirkungsgrade in einer idealen einstufigen Solarzellen nicht größer als etwa 33% sein können.

In einer herkömmlichen mono- oder polykristallinen Solarzelle werden durch einfallendes Licht Elektron-Lochpaare erzeugt, die durch das sich am pn-Übergang einstellende elektrische Feld zu den Kontakten bewegt werden. Aus der speziellen Lösung der Maxwellschen Gleichungen - der Poissongleichung - kann gezeigt werden, dass die Krümmung der sogenannten Bandkanten für die Bewegung der freien Ladungsträger über das sich einstellende elektrische Feld verantwortlich ist. Daher ergeben sich in einer Standard-Solarzelle vor allem folgende Verlust-Mechanismen:
- Räumliche Verteilung der Lichtabsorption im Silizium, sprich Erzeugung von Elektronlochpaaren in den Bahngebieten, die teilweise rekombinieren
- Rekombination der Elektron-Lochpaare beim Durchlaufen der Raumladungszonen und Bahngebiete - Lebensdauer der Ladungsträger
- Thermalisierung der Elektron-Lochpaare in den Bahngebieten
- Ohmsche Verluste in den Bahngebieten und Anschlussgebieten
- Kontaktwiderstandsverluste
- Abschattung durch die Frontkontakte
- Reflektion an der Zelloberfläche - vor allem für hochfrequente Strahlung - Texturierung ist notwendig
- Abhängigkeit der Eindringtiefe von der Lichtfrequenz
- Temperaturabhängigkeit des Wirkungsgrad durch Verringerung des Bandabstands und erhöhter Rekombination der Ladungsträger, sprich kleinerer Lebensdauer - Eigenleitung
- Die Quanteneffizienz ist auf 1 beschränkt.

Die Aufgabe der vorliegenden Erfindung ist es eine hocheffiziente produktionstaugliche Solarzelle vorzuschlagen, die die Nachteile herkömmlicher Solarzellen mittels einer eingefügten Quantenstruktur in den pn-Übergang überwindet und vor allem die Kopplung zwischen der Höhe der Diffusionsspannung, bzw. U_{oc} und der breite Raumladungszone, bzw. aktiven Schicht aufhebt. Außerdem soll die Thermalisierung von erzeugten Elektronen und die Rekombination von erzeugten Ladungsträgern verringert werden. Darüber hinaus sollen durch die Einführung eines Materials mit höherer Quantenabsorption die Gesamtschichtdicken bei höherem Wirkungsgrad reduziert werden. Außerdem wird die Anforderung der kostengünstigen Produktionstauglichkeit an die neuartige Solarzelle gestellt.

### Beschreibung der Erfindung

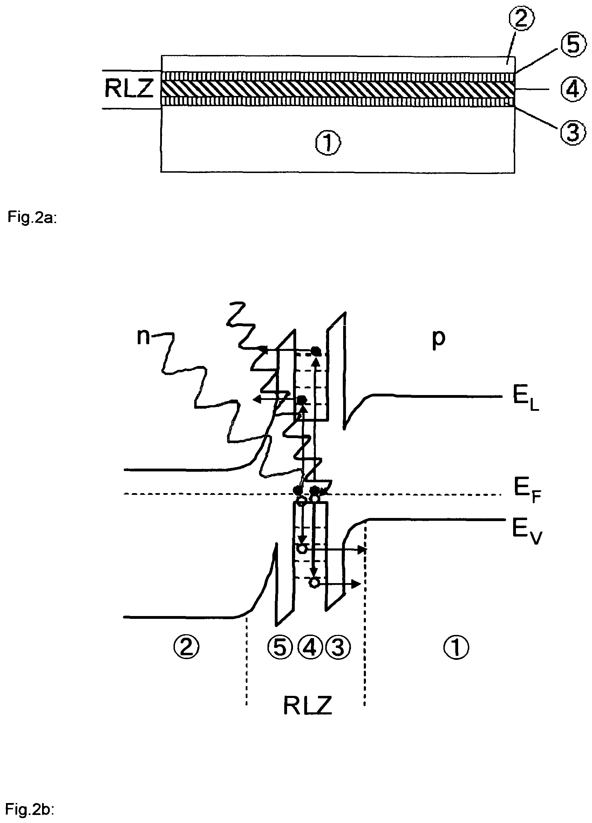

Im Gegensatz zu Solarzellen nach dem Stand der Technik, Fig 1a, wird eine Diode mit einer Bandstruktur wie in Fig.2b dargestellt vorgeschlagen. Die Solarzelle der vorliegenden Erfindung besteht aus zwei Tunnelbarrieren, die ein Gebiet aus z.B. Silizium Germanium einschließen. Diese Tripelheterostruktur wird in einen pn-Übergang eingebettet. Die eingefügten Schichten bestehen aus lediglich drei Bereichen; einem Material mit großem Bandabstand, z.B. SiC, einem Material mit kleinem Bandabstand, z.B. SiGe, und wieder einem Material mit großem Bandabstand. Das umgebende Material hat einen mittleren Bandabstand und könnte z.B. Silizium sein. Diese meist epitaktische Struktur wurde bereits in [1] beschrieben.

Da Silizium Germanium - z.B. 33% Germanium im gesamten interessierenden Wellenlängen Bereich eine etwa hundertfach höhere Absorption hat als Silizium können die relevanten Schichten ca. 100fach dünner sein als in einer Siliziumsolarzelle bei gleicher Lichtabsorption und Quanteneffizienz. Wie die Bandstruktur zeigt entstehen bei geeigneter Schichtdicke Minibänder, die dafür sorgen, dass jedes einfallende Photon eine Minibandkombination findet, die genau die Photonenergie in ein oder mehrere Elektron-Lochpaare wandelt. Durch das äußere Feld, das sich aufgrund der Diffusionsspannung des umgebenen pn-Übergangs einstellt, tunneln Elektronen ins Leitungsband des n-Gebiets und Löcher ins angrenzende p-Gebiet. Aufgrund dieser Methode werden die meisten Verlustmechanismen in der neuartigen Solarzelle unterdrückt.
- Es gibt eine Verteilung der Lichteindringtiefe auf nur wenige Nanometer, nämlich die Dicke der SiGe-Schicht
- Rekombination und Lebensdauer von Ladungsträger spielt für die neuartige Solarzelle kaum eine Rolle, da erzeugte Ladungsträger auch auf jeden Fall die Bahngebiete erreichen.
- Thermalisierung findet vermutlich kaum statt, da Elektronen und Löcher von den Minibändern - entsprechenden Energieniveaus - sofort die Kontaktgebiete über den Tunneleffekt und das äußere elektrische Feld erreichen können.
- Reflektion spielt nur eine untergeordnete Rolle, da jedes Photon, dass nur wenige nm in die Oberfläche der neuartigen Zelle eindringt, auch schon in elektrische Energie umgewandelt wird. Dies birgt den Vorteil unabhängiger vom Einstrahlwinkel zu sein.
- Die neuartige Zelle ist thermisch gesehen viel unabhängiger, da die SiGe-Schicht sehr dünn ist und gleichzeitig bis zur Entartung dotiert ist, so dass Änderungen des Bandabstands nur einen geringen Einfluss auf die Solarzelle haben werden. Der quantenmechanische Tunneleffekt ist nahezu temperaturunabhängig.
- Die sich einstellende Diffusionsspannung kann unabhängig vom Lichtabsorber eingestellt werden.
- Die Struktur und Messungen an Teststrukturen legt nahe, dass sich eine Quanteneffizienz von größer als eins realisieren lassen, da Elektron-Loch-Paare die z.B. mittels UV-Licht erzeugt wurden beim Fall auf niedrigere Energieniveaus weitere Elektron-Loch Paare erzeugen können.
- Die spektrale Empfindlichkeit SR der innovativen Solarzelle wird aufgrund der Nutzung einer dünnen Schicht, in der Licht mit verschiedenen Wellenlängen hergestellt wird, höher sein als in Standardsolarzellen.
- Durch die jeweils für Löcher und Elektronen angrenzenden Barrieren wird die Löcher- und Elektronen-Rückdiffusion nahezu vollständig unterdrückt.

### Beschreibung der Figuren und Wirkungsweise

Fig.1a zeigt schematisch eine herkömmliche Solarzelle mit einem pn-Übergang. Dabei nutzt man meistens einen p-dotierten Wafer als Ausgangsmaterial für die Erzeugung der Schicht ①. Die n-dotierte Schicht ② wird meistens durch eine Phosphordiffusion erzeugt und hat einen Gradienten, der hier nicht dargestellt ist. Es bildet sich am Übergang von n zu p die sogenannte Raumladungszone (RLZ) aus, die dadurch gekennzeichnet ist, dass aufgrund des starken Konzentrationsgradienten von n und p sich eine Zone ohne freie Ladungen und ein elektrisches Feld ausbildet. Der Einfachheit halber wurde auf die Darstellung der Kontakte und des Dotierungsgradienten, der durch die Eindiffusion der n-Gebiete entsteht, verzichtet. Im Bändermodell führt dies ohne angelegte Spannung zu Bandverbiegungen des Leitungsband E_{L} und des Valenzbandes E_{V}, die in Fig.1b schematisch dargestellt sind. Die sich einstellende Diffusionsspannung, die in etwa der Klemmenspannung U_{C0} entspricht, ist der Unterschied zwischen der Leitungsbandkante im n-Gebiet ② und der Leitungsbandkante im p-Gebiet ① und hängt vor allem von der Dotierung der beiden Gebiete ab. Üblicherweise liegt sie bei Solarzellen bei etwa 0,6V. Bei üblichen Solarzellen liegt die Breite der RLZ bei etwa einigen 100nm. Nur in dem Gebiet, in dem ein Gradient der Bänder vorliegt, d.h. Leitungs- und Valenzband verlaufen nicht parallel zum Ferminiveau, werden erzeugte Elektron-Loch Paare durch das sich einstellende elektrische Feld zu den Klemmen der Diode bewegt und tragen damit effektiv zum Stromfluss bei Anschluss an einen Verbraucher bei. Aufgrund der Kopplung von Diffusionsspannung, Breite der RLZ und Dotierung sind die Optimierungsmöglichkeiten einer solchen Solarzelle stark limitiert. Wenn nun Licht auf diese Solarzelle fällt mit Wellenlängen unter etwa 1000nm werden Elektron-Loch Paare in der RLZ erzeugt. Jedoch Licht mit größeren Wellenlängen, z.B. Infrarot, hat nicht genug Energie, um Valenzelektronen aus ihren Bahnen zu schlagen und damit photonische Energie in elektrische umzuwandeln. Licht mit kürzen Wellenlängen hat zuviel Energie, so dass die erzeugten Elektron-Loch-Paare bis zu den Klemmen wieder auf Leitungs- bzw. Valenzbandniveau zurückfallen und dabei lediglich Wärme erzeugen.

Fig.2 a zeigt schematisch den Schichtaufbau der hier vorgeschlagenen neuartigen Solarzelle, bei der Diffusionsspannung, sowie äußere Dotierungen vollkommen entkoppelt sind, durch die Einführung der Tunnelbarrieren aus einem Widegap-Material, z.B. SiC oder SiO₂. Man geht wie bei einer herkömmlichen Zelle von einem p-dotierten Wafer ①, z.B. Si, aus. Jedoch anstelle der Eindiffusion eines n-Gebietes werden mittels eines epitaktischen oder ähnlichen Abscheideverfahrens mindestens vier weitere Schichten aufgebracht. Zunächst eine Schicht von 1-10nm eines Materials mit großem Bandabstand ③ , z.B. SiC, dann ein Material mit kleinem Bandabstand ④, z.B. SiGe mit Dicken zwischen 5 und 25nm, und wieder ein Material mit großem Bandabstand von 1-10nm. Dabei ist entscheidend, dass bei den Dicken der Schichten ③ und ⑤ Tunnelbedingungen für Löcher und Elektronen erfüllt sind. Die Schicht ④ wird günstigere Weise in der Dicke so eingestellt, dass sich sogenannte Minibänder einstellen. Die Schicht ② ist n-dotiert und dient als Kontaktschicht aber auch zur Einstellung der gewünschten Diffusionsspannung.

Fig.2b zeigt den sich einstellenden Bandverlauf einer solchen Solarzelle. In die beiden Anschlussgebiete ① und ② ist eine Quantenstruktur eingebettet aus zwei Tunnelbarrieren ③ und ⑤, in dessen Mitte ein Quantentopf ④ aus einem Material mit niedrigem Bandabstand entsteht. Bei optimierter Dicke der Schicht ④ kann davon ausgegangen werden, dass sich wie in Fig.2b dargestellt ist, in diesem Bereich Minibänder, d.h. quantisierte Energieniveaus ausbilden.

Durch diese eingebettete Struktur sind die n- und p-dotierten Anschlussgebiete ① und ② von der Absorberstruktur getrennt, d.h. die Diffusionsspannung ist in einem gewissen Bereich frei einstellbar. Wenn man davon ausgeht, dass die beiden umgebenden Schichten aus Si sind, können Diffusionsspannungen von bis zu 1,1V eingestellt werden. Dies wäre etwa eine Verdoppelung zu herkömmlichen Solarzellen.

Fällt nun Licht auf eine solche Struktur werden Elektron-Loch Paare ab der Energielücke des Materials mit niedrigem Bandabstand erzeugt, z.B. 1500 -1700nm für SiGe. Durch die Diffusionsspannung zwischen ① und ② werden Elektronen sofort nach deren Generation ins n-Gebiet ② tunneln und Löcher ins p-Gebiet ①. Dadurch kommt bei Anschluss der Zelle an einen Verbraucher ein Stromfluss zustande. Dabei findet fast jede Lichtwellenlänge eine passende Kombination von Energieniveaus, so dass Verluste durch Thermalisierung wie in herkömmlichen Solarzellen minimiert werden. Darüber hinaus kann angenommen werden, dass die Quanteneffizienz größer als eins sein kann, zurückfallende Elektron-Lochpaare, die z.B. durch hochenergetisches UV Licht erzeugt werden, finden unterhalb wieder Niveaus und können dort weitere Elektron-Loch Paare erzeugen. Damit funktioniert, die vorgestellte Solarzelle prinzipiell wie ein umgekehrter Laser. Die Lichtabsorption, die in der neuen Struktur nur auf einigen Nanometer in die Tiefe stattfindet, wird dabei unterstützt von der Tatsache, dass z.B. Si₇₅Ge₂₅ eine um einen Faktor 20 - 50 höhere Absorption im gesamten Wellenlängenbereich hat als reines Silizium, so dass wenn man annimmt, dass die RLZ in Standardsolarzellen ca. 500nm ist, wird eine RLZ mit 10 - 25nm mindestens so effektiv sein, wie die in herkömmlichen Zellen.

Aus der gleichen Absorption, breites nutzbares Lichtwellenlängenspektrum von ca. 1700nm - 300nm, höherer Diffusionsspannung, geringere Thermalisierung und damit einer höheren mittleren Stromdichte kann man annehmen, dass die Wirkungsgrade deutlich höher sein werden als in Standardsolarzellen. Wie dies an kleinen Mustern auch schon demonstriert wurde.

### Beschreibung der Abbildungen:

Fig.1a: Schichtfolge einer herkömmlichen Solarzelle
Fig1b.: Schematischer Bandverlauf einer einstufigen Solarzelle mit Leitungsbandkante E_{L}, Valenzbandkante E_{V} und Ferminiveau E_{F} mit angedeuteter Einstrahlung von rotem und ultraviolettem Licht. ● Elektron, ○ Loch, RLZ (Raumladungszone).
Fig.2a: Halbleiterschichtfolge des zweipoligen Bauelements mit ① p-dotiertem Bereich, ② und ④ Material mit großem Bandabstand, ③ Halbleitermaterial mit kleinem Bandabstand, und der Schicht ⑤ aus n-leitendem Material
Fig.2b: Schematischer Bandverlauf des neuen zweipoligen Bauelements mit angedeuteter Einstrahlung von rotem und ultraviolettem Licht. ● Elektron, ○ Loch, RLZ (Raumladungszone).

### Literatur

[1] DE 10 2005 047 221 A1, 2005
[2] Albert Einstein: Über einen die Erzeugung und Verwandlung des Lichtes betreffenden heuristischen Gesichtspunkt. In: Annalen der Physik. 322, Nr. 6,, S. 132-148, 1905
[3] Ibach-Lüth, Festkörperphysik, Einführung in die Grundlagen, 2002
[4] M. S. Sze, Physics of Semicconductor Devices, Wiley & Sohn, 1981
[5] Rubin Braunstein, Arnold R. Moore and Frank Herman, Intrinsic Optical Absorption in Germanium-Silicon Alloys, Phys. Rev. 109, 695-710, 1958
[6] Richard Feynman: QED. Die seltsame Theorie des Lichts und der Materie ISBN 3-492-21562-9 - 1987

## Patentansprüche

1. Ein zweipoliges Halbleiterbauelement aus mindestens fünf Schichten, das Licht in elektrischen Strom wandelt, wozu eine Heterostruktur in einen pn-Übergang eingebettet wird, also Schichten solchermaßen vorgesehen sind,
a) dass die erste Schicht aus einem p-dotierten Halbleitermaterial mit einem Bandabstand X besteht,
b) dass die zweite und vierte Schicht aus einem Material mit größerem Bandabstand Y besteht und eine Dicke hat, die Ladungsträger tunneln erlaubt,
c) dass die dritte Schicht aus einem Material mit kleinerem Bandabstand Z besteht und aus einem Material mit hoher Lichtabsorption besteht und,
d) dass die fünfte Schicht aus einem n-dotierten Halbleitermaterial mit einem Bandabstand X besteht,
sodass zwischen der ersten Schicht und der fünften Schicht eine Quantenstruktur eingebettet ist aus zwei Tunnelbarrieren, nämlich der zweiten und der vierten Schicht, in deren Mitte die dritte Schicht angeordnet ist,
wobei eine der Schichten unter a) und d) so dünn ist, dass einfallendes Licht die übrigen Schichten erreicht,
**dadurch gekennzeichnet, dass**
in den pn-Übergang genau drei Schichten eingebettet sind, also eine Tripelheterostruktur eingebettet ist, und
die dritte Schicht so dünn ist, dass sich Minibänder, das heißt quantisierte Energieniveaus, zwischen der zweiten und vierten Schicht ausbilden.

2. Halbleiterschichtstruktur für elektronisches Bauelement nach Anspruch 1, **dadurch gekennzeichnet, dass** die erste und fünfte Schicht aus Silizium, die zweite und vierte Schicht mindestens aus Silizium und Kohlenstoff und die dritte Schicht aus Silizium Germanium (SiGe) besteht.

3. Halbleiterschichtstruktur für elektronisches Bauelement nach einem der vorangegangenen Ansprüche, **dadurch gekennzeichnet, dass** die Schichten mittels eines CVD, MBE oder eines ähnlichen Verfahrens aufgebracht werden.

4. Halbleiterschichtstruktur für elektronisches Bauelement nach einem der vorangegangenen Ansprüche, **dadurch gekennzeichnet, dass** die Schichtfolge nach Anspruch 1 durch Materialien der Gruppe II, III, V und VI realisiert werden.

5. Halbleiterschichtstruktur für elektronisches Bauelement nach einem der vorangegangenen Ansprüche, **dadurch gekennzeichnet, dass** die Schichten auf einkristallinen Siliziumwafern oder auf multikristallinen Siliziumwafern oder auf Siliziumfolie oder auf Glas oder auf metallbeschichtetem Glas abgeschieden werden.

6. Halbleiterschichtstruktur für elektronisches Bauelement nach einem der vorangegangenen Ansprüche, **dadurch gekennzeichnet, dass** mittels üblicher Verfahren aus den Schichten eine Solarzelle gefertigt wird.

## Claims

1. A bipolar semiconductor device comprising at least five layers, provided for converting light into an electrical current, wherein a heterostructure is embedded into a pn-junction for that purpose, the layers being provided in such a way
a) that the first layer consists of a p-doped semiconductor material having a band gap X,
b) that the second and fourth layer consist of a material having a larger band gap Y and have a thickness allowing a tunneling of charge carriers,
c) that the third layer consists of a material having a smaller band gap Z and of a material with a high light absorption and,
d) that the fifth layer consists of a n-doped semiconductor material having a band gap X,
so that, between the first layer and the fifth layer, a quantum structure is embedded made of two tunnel barriers, namely the second and the fourth layer, the third layer being arranged in the middle thereof,
wherein a layer according to a) or d) is so thin that incident light reaches the remaining layers,
**characterized in that**
exactly three layers are embedded into the pn-junction so that a triple heterostructure is embedded and
the third layer is so thin that mini bands form between the second and the fourth layer, namely quantized energy levels.

2. Semiconductor layer structure for an electronic device according to claim 1, **characterized in that** the first and fifth layer are made of silicon, the second and fourth layer are made at least of silicon and carbon and the third layer is made of silicon germanium (SiGe).

3. Semiconductor layer structure for an electronic device according to one of the preceding claims, **characterized in that** the layers are deposited by a CVD, MBE or the like process.

4. Semiconductor layer structure for an electronic device according to one of the preceding claims, **characterized in that** the layer sequence according to claim 1 is realized by materials of groups II, III, V and VI.

5. Semiconductor layer structure for an electronic device according to one of the preceding claims, **characterized in that** the layers are deposited on a crystalline silicon wafer or on a multicrystalline silicon wafer or on silicon foil or on glass or on metal coated glass.

6. Semiconductor layer structure for an electronic device according to one of the preceding claims, **characterized in that** a photovoltaic cell is manufactured from the layers by common processes.

## Revendications

1. Composant semi-conducteur bipolaire composé d'au moins cinq couches, ledit composant transformant la lumière en courant électrique, aux fins de quoi une structure hétérogène est incorporée dans une jonction PN, lesdites couches étant prévues de manière que:
a) la première couche se compose d'un matériau semi-conducteur dopé P avec une bande interdite X,
b) la deuxième et la quatrième couche se composent d'un matériau avec une plus large bande interdite Y et une épaisseur permettant le passage de porteurs de charge par effet tunnel,
c) la troisième couche se compose d'un matériau à bande interdite plus étroite Z et d'un matériau à plus grande absorption de lumière, et
d) la cinquième couche se compose d'un matériau semi-conducteur dopé N avec une bande interdite X,
si bien qu'une structure quantique est incorporée entre la première couche et la cinquième couche, laquelle structure quantique se compose de deux barrières à effet tunnel, à savoir la deuxième et la quatrième couche, au centre desquelles est disposée la troisième couche;
dans lequel l'une des couches citées en a) et d) est suffisamment mince pour que la lumière incidente parvienne aux couches restantes,
**caractérisé en ce que**
trois couches exactement sont incorporées dans la jonction PN, c'est-à-dire qu'il est incorporé une structure hétérogène triple, et
la troisième couche est suffisamment mince pour que des mini-bandes, c'est-à-dire des niveaux d'énergie quantifiés, se forment entre la deuxième et la quatrième couche.

2. Structure en couches semi-conductrice pour composant électronique selon la revendication 1, **caractérisée en ce que** la première et la cinquième couche se composent de silicium, la deuxième et la quatrième couche se composent au moins de silicium et de carbone, et la troisième couche se compose de silicium-germanium (SiGe).

3. Structure en couches semi-conductrice pour composant électronique selon l'une quelconque des revendications précédentes, **caractérisée en ce que** les couches sont appliquées par dépôt chimique en phase vapeur, épitaxie par jet moléculaire ou autre procédé similaire.

4. Structure en couches semi-conductrice pour composant électronique selon l'une quelconque des revendications précédentes, **caractérisée en ce que** la succession de couches selon la revendication 1 est réalisée par des matériaux des groupes II, III, V et VI.

5. Structure en couches semi-conductrice pour composant électronique selon l'une quelconque des revendications précédentes, **caractérisée en ce que** les couches sont déposées sur des plaquettes de silicium monocristallin ou sur des plaquettes de silicium polycristallin ou bien sur une feuille de silicium, ou sur du verre ou bien du verre métallisé.

6. Structure en couches semi-conductrice pour composant électronique selon l'une quelconque des revendications précédentes, **caractérisée en ce que** l'on produit une cellule solaire à partir desdites couches au moyen de procédés usuels.
